# EUROPÄISCHE PATENTANMELDUNG

(11) **EP 4 645 034 A1**
(43) Veröffentlichungstag der Anmeldung: **05.11.2025**
(21) Anmeldenummer: 24174137.0
(22) Anmeldetag: 03.05.2024
(51) Int. Cl.: G06F 1/20, F28D 15/02, H01L 23/427

(54) **KÜHLER UND VERFAHREN ZUM KÜHLEN EINES PROZESSORS**

(71) Anmelder: TechN GmbH, 12099 Berlin (DE)
(72) Erfinder: Kohl, Nikolaus, 10999 Berlin (DE)
(74) Vertreter: Pfenning, Meinig & Partner mbB

(57) **Zusammenfassung**

Die vorliegende Erfindung betrifft einen Kühler zum Kühlen eines Prozessors, insbesondere einer CPU oder einer GPU, und ein Verfahren zum Kühlen eines Prozessors unter Verwendung des Kühlers. Die CPU bzw. die GPU sind typischerweise Bestandteil eines Desktop-PCs.

## Beschreibung

Die vorliegende Erfindung betrifft einen Kühler zum Kühlen eines Prozessors, insbesondere einer CPU oder einer GPU, und ein Verfahren zum Kühlen eines Prozessors unter Verwendung des Kühlers. Die CPU bzw. die GPU sind typischerweise Bestandteil eines Desktop-PCs.

Ein Kühler zum Kühlen eines Prozessors sorgt dafür, dass der Prozessor stets in einem bestimmten Temperaturbereich gehalten wird. Denn der Prozessor, insbesondere eine CPU oder GPU, produziert Abwärme, wenn er arbeitet. Je nachdem, wie stark er beansprucht wird, kann er ohne Kühlung so heiß werden, dass entweder die Leistung mittels Schutzschaltung herabgesetzt wird oder die Technik beschädigt wird.

Moderne Prozessoren haben üblicherweise als Schutz vor Überhitzung einen Drossel oder Abschaltmechanismus. Ein Hauptgrund für bessere Kühlung ist daher Leistungsverlust bei Drosselung.

Um einer derartigen Drosselung oder Hitze entgegenzuwirken, werden geeignete Kühler verwendet, die die Abwärme von Prozessoren wie CPUs oder GPUs abführen.

Aus dem Stand der Technik sind Flüssigkeitskühler zum Kühlen eines Prozessors mittels Kühlflüssigkeit bekannt. Beispielsweise weist ein derartiger Kühler mehrere Kühlfinnen in einem Kühlkanal auf, durch die eine Kühlflüssigkeit geleitet wird. Der Prozessor steht in thermischem Kontakt mit dem Kühlkanal, sodass die Kühlflüssigkeit die Abwärme des Prozessors aufnimmt. Die Aufnahme der Abwärme des Prozessors erfolgt über Übertragung in die Wärme der Kühlflüssigkeit.

Neben den Flüssigkeitskühlern sind luftbasierte Kühler zum Kühlen von Prozessoren bekannt, die jedoch im Vergleich zu Flüssigkeitskühlern die Wärme weniger gut abtransportieren und störenden Lärm oder Geräusche erzeugen.

Darüber hinaus steigen Leistungen von Prozessoren, insbesondere CPU oder GPU ständig, was zu einer erheblichen Zunahme der Abwärme führt und eine stärkere Kühlung erfordert.

Es besteht im Allgemeinen daher der Bedarf, die Kühler aus dem Stand der Technik zu verbessern bzw. weiterzuentwickeln, um dem Anstieg der Abwärme von Prozessoren entgegenzuwirken und die Kühlwirkung zu erhöhen.

Ausgehend von den zuvor erläuterten technischen Problemen liegt der Erfindung die Aufgabe zugrunde, einen Kühler zum Kühlen eines Prozessors, insbesondere einer CPU oder einer GPU, und ein Verfahren zum Kühlen eines Prozessors unter Verwendung des Kühlers bereitzustellen.

Die vorstehende Aufgabe wird mit einem Kühler zum Kühlen eines Prozessors und mit einem Verfahren zum Kühlen eines Prozessors unter Verwendung des Kühlers gemäß den unabhängigen Ansprüchen gelöst. Weitere vorteilhafte Ausführungsformen und Ausgestaltungen der Erfindung sind Gegenstände der abhängigen Ansprüche.

Gemäß einem Aspekt wird ein Kühler zum Kühlen eines Prozessors, insbesondere einer CPU oder einer GPU bereitgestellt. Der Kühler umfasst einen Kühlkörper, welcher eine Dampfkammer (Englisch: Vapor Chamber) für ein erstes Kühlfluid und einen Kühlkanal zum Durchleiten einer zweiten Kühlflüssigkeit, der durch den Kühlkörper verläuft, aufweist. In der Regel ist die Dampfkammer eine geschlossene Kammer und kann eine verschließbare Öffnung für die Einführung des ersten Kühlfluids aufweisen.

Die Dampfkammer weist eine erste Kühlfläche und eine der ersten Kühlfläche gegenüberliegende zweite Kühlfläche auf. Auf der ersten Kühlfläche der Dampfkammer ist der Prozessor anordenbar, der Prozessor kann also mit der ersten Kühlfläche der Dampfkammer in thermischem Kontakt, vorzugsweise in direktem thermischen Kontakt, stehen. Durch Wärme des Prozessors ist das erste Kühlfluid zwischen gasförmigem und flüssigem Zustand in der Dampfkammer umwandelbar. Die vorliegende Erfindung nutzt den Phasenübergang des ersten Kühlfluids, um die Abwärme des Prozessors an die zweite Kühlflüssigkeit zu übertragen.

Die zweite Kühlfläche der Dampfkammer ist dem Kühlkanal zugewandt und verläuft im Wesentlichen parallel zum Kühlkanal. Parallel soll im Sinne dieser Schrift bedeuten, dass ein Winkel zwischen der zweiten Kühlfläche der Dampfkammer und dem Kühlkanal weniger als 10°, vorzugsweise weniger als 5°, beträgt.

Eine Vielzahl von parallelen Kühlrippen ist auf der zweiten Kühlfläche der Dampfkammer angeordnet und senkrecht zur zweiten Kühlfläche der Dampfkammer ausgerichtet. Darüber hinaus sind die Kühlrippen entlang einer Strömungsrichtung der zweiten Kühlflüssigkeit und parallel zur Strömungsrichtung der zweiten Kühlflüssigkeit derart im Kühlkanal angeordnet, dass die zweite Kühlflüssigkeit durch die Kühlrippen und auf der zweiten Kühlfläche strömbar ist bzw. strömt. Diese Anordnung ermöglicht den effektiven und effizienten Durchfluss der zweiten Kühlflüssigkeit durch den Kühlkanal.

Die Dampfkammer umfasst typischerweise ein Gehäuse, wobei die beiden Kühlflächen in der Regel als Gehäusewände der Dampfkammer oder Bestandteile der Gehäusewände ausgebildet sind.

Wenn der Prozessor auf die erste Kühlfläche der Dampfkammer gebracht und betrieben wird, wird die vom Prozessor generierte Abwärme auf die erste Kühlfläche der Dampfkammer übertragen, wodurch das erste Kühlfluid in der Dampfkammer verdampft, d. h. von flüssig zu gasförmig wird.

Die erste Kühlfläche kann eine Außenseite und eine Innenseite aufweisen, wobei der Prozessor auf der Außenseite angeordnet wird und die Innenseite dem Hohlraum der Dampfkammer zugewandt ist. Ebenso kann die zweite Kühlfläche eine Außenseite und eine Innenseite aufweisen, wobei die Außenseite dem Kühlkanal zugewandt ist und die Innenseite dem Hohlraum der Dampfkammer zugewandt ist. Die Innenseite der ersten Kühlfläche kann auch als Verdampfungsbereich (s. unten) aufgefasst werden, während die Innenseite der zweiten Kühlfläche als Kondensationsbereich aufgefasst werden kann (s. unten).

Das gasförmige erste Kühlfluid wird durch die Innenseite der zweiten Kühlfläche, auf deren gegenüberliegenden Seite, also der Außenseite der zweiten Kühlfläche, die zweite Kühlflüssigkeit strömt, gekühlt. Während des Kühlvorgangs überträgt das erste Kühlfluid in der Dampfkammer die Abwärme an die zweite Kühlflüssigkeit und geht dabei vom gasförmigen zu dem flüssigen Zustand über, kondensiert also an der Innenseite der zweiten Kühlfläche. Die Dampfkammer kann im bestimmungsgemäßen Gebrauch optional derart angeordnet bzw. ausgerichtet sein, dass das gasförmige Kühlfluid von der ersten Kühlfläche aufsteigt und an der zweiten Kühlfläche kondensiert. Unter der Wirkung der Schwerkraft tropft das flüssige erste Kühlfluid dann zurück in Richtung der ersten Kühlfläche der Dampfkammer. Eine bestimmte Anordnung oder Ausrichtung der Dampfkammer zur Schwerkraft ist aber nicht notwendig für das Funktionieren der Dampfkammer. So kann die Dampfkammer alternativ im bestimmungsgemäßen Gebrauch des Kühlers derart angeordnet bzw. ausgerichtet sein, dass das gasförmige Kühlfluid von der Innenseite der ersten Kühlfläche absinkt und an der Innenseite der zweiten Kühlfläche kondensiert. In einer weiteren alternativen Ausführungsform kann sich das gasförmige Kühlfluid seitlich von der Innenseite der ersten Kühlfläche zur Innenseite der zweiten Kühlfläche bewegen und dort kondensieren. Das an der zweiten Kühlfläche kondensierte erste Kühlfluid kann alternativ oder zusätzlich entlang der Säulen oder Fäden (s. Ausführungen unten) von der zweiten Kühlfläche Fläche zur ersten Kühlfläche gelangen, beispielsweise aufgrund einer Kapillarwirkung. Daher kann das kondensierte Kühlfluid entlang der Schwerkraft aber auch entgegen der Schwerkraft zur ersten Kühlfläche gelangen. Strömt die zweite Kühlflüssigkeit über die Kühlrippen, so wird die von der zweiten Kühlflüssigkeit aufgenommene Abwärme abgeführt. Die vorliegende Erfindung nutzt daher den Phasenübergang des ersten Kühlfluids in der Dampfkammer, um die Abwärme des Prozessors an die zweite Kühlflüssigkeit im Kühlkanal zu übertragen.

Dadurch, dass der Prozessor nicht in direktem thermischen Kontakt mit dem Kühlkanal wie im Stand der Technik steht, sondern auf der ersten Kühlfläche der zusätzlichen Dampfkammer angeordnet ist, können eine gleichmäßig homogene Wärmeabfuhr erreicht werden.

Die erste Kühlfläche kann als Außenkühlfläche betrachtet werden, da die erste Kühlfläche an einer Außenseite des Kühlers vorgesehen ist. Die zweite Kühlfläche kann als Innenkühlfläche angesehen werden, da die zweite Kühlfläche an einer Innenseite des Kühlers vorgesehen ist. Beispielswiese kann eine Wand des Kühlkanals durch die zweite Kühlfläche der Dampfkammer gebildet sein.

Es kann vorgesehen sein, dass die Form des Kühlkörpers an den zu kühlenden Prozessor angepasst ist. Um die vom Prozessor generierte Abwärme optimal abzuführen, kann die erste Kühlfläche der Dampfkammer so ausgebildet sein, dass sie an eine der ersten Kühlfläche zugewandte (Teil)oberfläche des Prozessors angepasst ist. Unabhängig davon kann die erste Kühlfläche der Dampfkammer teilweise oder vollständig durch Beschichtungen oder Oberflächenbearbeitungsverfahren derart konfiguriert werden, dass ihr Wärmeübertragungskoeffizient erhöht wird.

Der Verlauf des Kühlkanals und/oder der Verlauf der Kühlrippen können an die Geometrie des Kühlkörpers angepasst sein. Zum Beispiel können der Verlauf des Kühlkanals und/oder der Verlauf der Kühlrippen zumindest teilweise mäanderförmig sein, um eine möglichst große Wärmeübertragungsfläche zu erzeugen. Sowohl die Form als auch der Flächeninhalt eines Querschnitts des Kühlkanals und/oder der Kühlrippen können entlang des Verlaufs variieren und müssen nicht konstant sein. Der Kühlkanal bzw. Kühlrippen können abschnittsweise im Querschnitt rund und/oder polygonförmig wie rechteckig oder trapezförmig sein.

An einem Einlass und einem Auslass des Kühlkanals können Befestigungsmittel für Fluidleitungen angeordnet sein, sodass die zweite Kühlflüssigkeit über eine erste Fluidleitung zum Einlass des Kühlkanals eingeleitet und über eine zweite vom Auslass des Kühlkanal ausgeleitet wird. In optionalen Ausgestaltungsformen kann der Kühlkanal so ausgebildet sein, dass die Funktion des Kühlers von einer Flussrichtung der zweiten Kühlflüssigkeit unabhängig ist. In diesen optionalen Fällen sind Einlass und Auslass des Kühlkanals in der obigen und nachfolgenden Beschreibung folgenlos vertauschbar.

Der Kühler kann auch zum Kühlen mehrerer Prozessoren geeignet sein, die beispielsweise auf einer Platine angeordnet sind. Die Platine kann auf der ersten Kühlfläche der Dampfkammer abnehmbar angeordnet sein. Alternativ können mehrere Prozessoren nebeneinander auf der ersten Kühlfläche der Dampfkammer anordenbar sein. Außerdem ist der beschriebene Kühler nicht auf die Kühlung des Prozessors beschränkt. Andere elektronische Komponenten, die während des Betriebs Abwärme generieren, können ebenfalls durch den Kühler gekühlt werden.

In einer vorteilhaften Ausführungsform können die Kühlrippen integraler Bestandteil eines Gehäuses der Dampfkammer sein. Zum Beispiel können die Kühlrippen in eine Deckplatte der Dampfkammer eingeformt sein. Alternativ können die Kühlrippen durch eine separate Platte ausgebildet sein, die mit der zweiten Kühlfläche der Dampfkammer verbunden ist. Die genannte Verbindung ist üblicherweise mechanisch und thermisch und kann mittels geeigneter Mittel hergestellt sein. Die separate Platte liegt vorzugsweise flächig an der zweiten Kühlfläche an.

Der Kühler kann eine Befestigungseinrichtung für den Prozessor aufweisen. Die Befestigungseinrichtung kann oftmals derart ausgebildet sein, dass eine zerstörungsfrei lösbare Verbindung mit dem Prozessor möglich ist. Weiterhin ist es möglich, dass die erste Kühlfläche der Dampfkammer die Befestigungseinrichtung für den Prozessor umfasst. Alternativ kann die Befestigungseinrichtung an einer anderen Stelle im Kühler angeordnet sein. Zum Beispiel kann der Kühlkörper ein Gehäuse aufweisen, durch welches der Kühlkanal verläuft, und eine Befestigungseinrichtung für den Prozessor ist in oder an dem Gehäuse angeordnet.

Bevorzugt kann der Kühler abnehmbar an dem Prozessor befestigt werden. Wenn der Prozessor z. B. außer Betrieb oder kaputt ist, kann der Kühler von dem Prozessor abgenommen und für einen anderen zu kühlenden Prozessor eingesetzt werden. Wenn der Kühler kaputt ist oder gewartet werden soll, kann er von dem Prozessor abgenommen werden, ohne dass der Prozessor als Ganzes zusammen mit dem Kühler entsorgt werden muss. Diese Anordnung ermöglicht eine flexible Verwendung des Kühlers.

In den beiden Ausführungsformen kann ein Anpressdruck durch die Befestigungseinrichtung für den Prozessor erzeugt werden, der eine innige Verbindung zwischen der ersten Kühlfläche der Dampfkammer und dem Prozessor oder zwischen dem Gehäuse des Kühlkörpers und dem Prozessor ermöglicht. Die Befestigungseinrichtung für den Prozessor kann eine kraftschlüssige und/oder formschlüssige Verbindung ermöglichen. So kann die Befestigungseinrichtung Schrauben oder Klammern umfassen oder durch diese gebildet sein. Wärmeleitpads sind auch denkbar.

Vorteilhafterweise kann die erste Kühlfläche der Dampfkammer in direktem thermischen Kontakt mit dem Prozessor stehen, sodass die Abwärme des Prozessors gezielt in die Dampfkammer übertragen wird und damit Abwärmeverlust reduziert wird. Wenn sich beispielsweise weitere temperaturempfindliche elektronische Bauteile neben dem Prozessor in einem Desktop PC befinden, werden sie weniger oder gar nicht von der Abwärme des Prozessors beeinträchtigt.

In einer Ausgestaltung können die erste Kühlfläche der Dampfkammer und die zweite Kühlfläche der Dampfkammer parallel zueinander angeordnet sein. Für die Auslegung des Begriffs "parallel" wird auf die obige Ausführung verwiesen.

Obwohl die Abwärme des Prozessors im Wesentlichen durch die Verdampfung, Ausbreitung und Kondensation des ersten Kühlfluids verteilt und abgeführt wird, können die Abfuhr- und Verteilungseffekte durch die Geometrie und Wärmeleitfähigkeit des Materials der Dampfkammer weiterhin verbessert werden. In diesem Zusammenhang sieht eine weitere Ausgestaltung der Erfindung vor, dass die erste Kühlfläche der Dampfkammer und die zweite Kühlfläche der Dampfkammer durch eine erste Platte und eine zweite Platte ausgebildet sein können. Solche Platten verhindern lokale Überhitzung der Kühlflächen der Dampfkammer, da sich die Abwärme des Prozessors entlang der breiten Oberfläche der Platten schnell ausbreiten kann. Die erste Platte und/oder die zweite Platte können aus Materialien mit einer hohen Wärmeleitfähigkeit, insbesondere Kupfer, hergestellt sein. Beispielsweise kann ein Gehäuse der Dampfkammer eine Basisplatte als erste Platte und eine Deckplatte als zweite Platte aufweisen, welche miteinander verbunden sind.

Es sei angemerkt, dass die Platten sich nicht notwendigerweise auf eine vollständig flache Platte beziehen. Zum Beispiel kann eine der Platten als wannenförmige Platte ausgebildet sein. Ein Teil der wannenförmigen Platte, zum Beispiel der Teil mit der ersten oder zweiten Kühlfläche, kann als flache Platte ausgestaltet sein.

Es kann des Weiteren vorgesehen sein, dass der Kühler eine Pumpe umfasst, mittels der die zweite Kühlflüssigkeit durch die Kühlrippen im Kühlkanal pumpbar ist. Zusätzlich oder alternativ kann der Kühler einen geschlossenen Flüssigkeitskreislauf aufweisen, in welchem die zweite Kühlflüssigkeit zirkuliert. Insbesondere kann die zweite Kühlflüssigkeit mithilfe der Pumpe in den geschlossenen Flüssigkeitskreislauf derart gepumpt werden, dass die zweite Kühlflüssigkeit durch den Kühlkanal strömt, zum Beispiel durch einen Einlass in den Kühlkanal einströmt und anschließend durch einen Auslass aus dem Kühlkanal herausströmt. Die Anordnung ermöglicht einen automatischen Flüssigkeitskreislauf außerhalb der Dampfkammer.

In einer optionalen Ausgestaltung kann der Kühlkörper zumindest einen Sensor zum Steuern der Pumpe umfassen. Insbesondere können die Menge und Geschwindigkeit der zweiten Flüssigkeit durch den Sensor kontrolliert werden.

Die Dampfkammer kann einen Kondensationsbereich, einen Verdampfungsbereich und einen Hohlraum zwischen dem Kondensationsbereich und dem Verdampfungsbereich aufweisen. Der Kondensationsbereich grenzt hierbei an die zweite Kühlfläche der Dampfkammer, während der Verdampfungsbereich an die erste Kühlfläche der Dampfkammer angrenzt. In diesem Fall wird das flüssige erste Kühlfluid durch die Abwärme des Prozessors zunächst im Verdampfungsbereich verdampft. Das verdampfte gasförmige erste Kühlfluid verbreitet sich in der Dampfkammer und erreicht den Kondensationsbereich, wo es durch die Kälte der zweiten Kühlfläche bzw. der darauf strömenden zweiten Kühlflüssigkeit in den flüssigen Zustand umwandelt. Nach dem Kondensieren kann das flüssige erste Kühlfluid wieder zum Verdampfungsbereich gelangen. Falls sich die erste Kühlfläche und/oder die zweite Kühlfläche zum Beispiel im bestimmungsgemäßen Gebrauch des Kühlers senkrecht zur Schwerkraft erstrecken, und vorzugsweise die zweite Kühlfläche sich oberhalb der ersten Kühlfläche erstreckt, kann das erste Kühlfluid nach dem Verdampfen aufsteigen und an der zweiten Kühlfläche kondensieren. Aufgrund der Schwerkraft tropft das flüssige Kühlfluid nach unten in Richtung der ersten Kühlfläche. Dadurch entsteht ein Fluidkreislauf des ersten Kühlfluids in der Dampfkammer.

Optional kann zumindest eine Säule, z. B. Kupfersäule, als Abstandhalter für die zwei Kühlflächen im Hohlraum der Dampfkammer angeordnet sein. Oftmals kann das flüssige erste Kühlfluid entlang der Säule tropfen, wodurch der Kühlmittelfluss in der Dampfkammer befördert wird. Die mindestens eine Säule kann sich vom Verdampfungsbereich bis zum Kondensationsbereich im Hohlraum erstrecken. Wenn die erste Kühlfläche und die zweite Kühlfläche parallel zueinander sind, kann die zumindest eine Säule senkrecht zu den Kühlflächen angeordnet sein. In manchen Ausführungsformen ist eine Vielzahl derartiger Säulen vorgesehen, beispielsweise zehn oder mehr. Anstelle oder zusätzlich zur Säule kann auch eine Vielzahl von Fäden vorgesehen sein, welche sich vom Verdampfungsbereich bis zum Kondensationsbereich im Hohlraum erstreckt. Die Fäden können eine ähnliche Funktion bzw. ähnlichen Aufbau haben wie die Säulen. Beispielsweise können die Fäden die Beförderung des kondensierten Kühlfluids ausgebildet sein, zum Beispiel über eine Kapillarwirkung.

Dem Fachmann ist geläufig, dass es verschiedene Möglichkeiten in Dampfkammern bzw. verschiedene Ausgestaltungen von Dampfkammern gibt, das erste Kühlfluid vom Verdampfungsbereich zum Kondensationsbereich zu befördern und andersherum. Die vorliegende Anmeldung ist nicht auf eine bestimmte Weise der Kühlfluidbeförderung in der Dampfkammer beschränkt.

In einer Ausführungsform kann mindestens eine der Kühlrippen in Form einer gesägten Kühlrippe oder in Form einer wälzgeschälten (Englisch: Skiving) Kühlrippe ausgebildet sein.

Wenn die Kühlrippen als integraler Bestandteil des Gehäuses der Dampfkammer ausgebildet sind, kann der Säge- oder Wälzschälvorgang vor dem Zusammensetzen der Dampfkammer erfolgen.

Wenn die Kühlrippen durch die separate Platte ausgebildet sind, kann der Säge- oder Wälzschälvorgang auf der separaten Platte erfolgen. Die gesägte oder walzgeschälte Platte wird dann mit der zweiten Kühlfläche der Dampfkammer in der oben beschriebenen Weise in Wärmekontakt gebracht.

In einer weiteren Ausführungsform können mindestens eine, mehrere oder sämtliche der Kühlrippen und/oder ein Gehäuse der Dampfkammer aus Kupfer, Edelstahl, Titan oder Aluminium hergestellt sein. Diese Materialien weisen eine hohe Wärmeleitfähigkeit auf und übertragen die Abwärme des Prozessors schnell.

Es kann des Weiteren vorgesehen werden, dass der Kühlkörper ein Gehäuse aufweist und der Kühlkanal durch das Gehäuse verläuft. Das Gehäuse des Kühlkörpers kann aus Aluminium, vorzugsweise mittels Druckguss, hergestellt sein. Zusätzlich oder alternativ kann das Gehäuse oder zumindest ein Teil des Gehäuses des Kühlkörpers aus Kunststoff hergestellt sein, um das Gewicht des Kühlers zu reduzieren.

Weiter kann der Kühler ein Elastomerdichtungselement aufweisen. Das Gehäuse, insbesondere der Kühlkanal, kann mittels des zwischen dem Gehäuse und der Dampfkammer angeordneten Elastomerdichtungselements abgedichtet sein. Das Elastomerdichtungselement kann insbesondere den Kühlkanal nach außen abdichten. Das Elastomerdichtungselement kann alternativ oder zusätzlich ausgestaltet sein, die Dampfkammer mit dem Gehäuse des Kühlkörpers zu verbinden, beispielsweise stoffschlüssig und/oder formschlüssig zu verbinden. Dies ist insbesondere dann vorteilhaft, wenn die Materialien des Gehäuses (vorzugsweise Aluminium) und der Dampfkammer (vorzugsweise Kupfer) voneinander abweichen, und eine Lötverbindung oder Schweißverbindung nicht geeignet ist, um die Verbindung herzustellen.

Zusätzlich oder alternativ kann der Kühlkörper oder das Gehäuse des Kühlkörpers eine erste Schale und eine mit der ersten Schale verbundene zweite Schale aufweisen. Die beiden Schalen bilden dann den Kühlkanal. Mindestens eine der beiden Schalen und/oder das Gehäuse und/oder der Kühlkanal können eingerichtet sein, die Dampfkammer zumindest teilweise oder vollständig aufzunehmen. Optional weist die erste Schale z. B. eine erste Verbindungsfläche auf und die zweite Schale weist eine zweite Verbindungsfläche auf. Die Schalen liegen an der Verbindungsfläche an und sind an ihren jeweiligen Verbindungsflächen flächig miteinander verbunden, um den Kühlkörper bzw. das Gehäuse des Kühlkörpers, den Kühlkanal und gegebenenfalls die Aufnahme für die Dampfkammer zu bilden. Im Bereich der Verbindungsflächen kann der Kühlkanal senkrecht zu den Verbindungsflächen der Schalen verlaufen. An den Verbindungsflächen der Schalen kann ein weiteres Dichtelement vorgesehen sein, das eine Dichtung der Schalen gewährleistet. Die Schalen können über Verbindungsmittel, wie Schrauben, Bolzen, Klammern, oder Verbindungen mittels Fügen, Kleben und/oder Schweißen miteinander verbunden werden. Die beiden Schalen und/oder die Schalenbauteile können beispielsweise in einem Fräs-, Spitzguss-, einem Druckguss- oder einem 3D-Druckverfahren hergestellt werden. Mindestens eine der Schalen kann aus Aluminium hergestellt sein, vorzugsweise mittels Druckguss.

Das erste Kühlfluid in der Dampfkammer kann Wasser, Ethanol, Methanol, Ammoniak oder eine Mischung davon umfassen. Zusätzlich oder alternativ kann die zweite Kühlflüssigkeit Wasser ggf. Korrosionsschutzmittel und/oder Antifrostmittel umfassen. Das Antifrostmittel kann z. B. Glykol umfassen oder sein.

Die Größe der ersten Kühlfläche der Dampfkammer ist relativ flexibel. Sie kann je nach Bedarf gleich, klein, oder größer sein als eine der ersten Kühlfläche zugewandte Oberfläche des Prozessors, beispielsweise größer als das Zweifache der Oberfläche des Prozessors oder kleiner als das Zweifache der Oberfläche des Prozessors. Wenn der Kühler zum Kühlen von mehreren Prozessoren verwendet wird, kann die erste Kühlfläche der Dampfkammer relativ groß sein. Wenn der Kühler zum Kühlen nur eines Prozessors verwendet wird, kann die erste Kühlfläche der Dampfkammer gleich der der ersten Kühlfläche zugewandten Oberfläche des Prozessors sein.

Im Gegensatz dazu ist es bevorzugt, dass die zweite Kühlfläche der Dampfkammer gleich oder größer sein kann als der der ersten Kühlfläche zugewandte Oberfläche des Prozessors, vorzugsweise größer als das Zweifache der Oberfläche des Prozessors, sodass die Abwärme durch die zweite Flüssigkeit schnell abgeführt wird.

Außerdem wird ein System zur Kühlung eines Prozessors vorgeschlagen. Das System weist neben dem oben beschriebenen Kühler für einen Prozessor auch eine Pumpe und einen Radiator auf. Kühler, Pumpe und Radiator sind dabei über Fluidleitungen fluidisch miteinander verbunden, sodass die zweite Kühlflüssigkeit mit der Pumpe durch die Fluidleitungen, den Kühlkanal des Kühlers, und den Radiator gepumpt werden kann. Im Kühler wird an der zweiten Kühlfläche Wärme an die zweite Kühlflüssigkeit abgegeben. Die dadurch erwärmte zweite Kühlflüssigkeit wird darauffolgend durch den Radiator geleitet und gibt ihre Wärme an diesen ab. Der Radiator ist dabei in der Regel beabstandet zum Kühler angeordnet. Die wieder erkaltete zweite Kühlflüssigkeit wird daraufhin wieder in den Kühler zur zweiten Kühlfläche geleitet, die ihre Wärme wieder an die zweite Kühlflüssigkeit abgibt. Der beschriebene Kühlkreislauf erlaubt die Kühlung zumindest eines Prozessors, der seine Wärme an die erste Kühlfläche des Kühlers abgibt. Das System kann weiter einen Lüfter aufweisen, der dazu ausgebildet ist, den Radiator zu kühlen, und vorzugsweise am Radiator angeordnet ist.

Gemäß einem weiteren Aspekt wird ein Verfahren zum Kühlen eines Prozessors vorgeschlagen. Das Verfahren verwendet insbesondere den Kühler der zuvor beschriebenen Art.

In dem Verfahren wird der Prozessor auf der ersten Kühlfläche der Dampfkammer, z. B. mittels einer Befestigungseinrichtung wie oben beschrieben, befestigt, und anschließend gekühlt, indem die zweite Kühlflüssigkeit durch den Kühlkanal geleitet wird und das erste Kühlfluid durch die Wärme des Prozessors zwischen dem gasförmigen und dem flüssigen Zustand in der Dampfkammer umgewandelt wird.

Das Verfahren ist nicht auf die zwei Schritte beschränkt und kann weitere Schritte umfassen.

Im Folgenden wird die Erfindung ohne Beschränkung des allgemeinen Erfindungsgedankens anhand von Ausführungsbeispielen und unter Bezugnahme auf die Figuren näher erläutert. Gleiche Bezugszeichen kennzeichnen dabei gleiche oder entsprechende Merkmale. Die Merkmale können auch unabhängig vom konkreten Beispiel realisiert sein und zwischen den Beispielen kombiniert werden.

Es zeigen
- Figur 1:: eine Schnittdarstellung eines Kühlers zum Kühlen eines Prozessors;
- Figur 2:: eine Seitenansicht einer ersten Ausführungsform einer Dampfkammer zur Verwendung in dem Kühler gemäß Figur 1;
- Figur 3:: eine Seitenansicht einer zweiten Ausführungsform einer Dampfkammer zur Verwendung in dem Kühler der Figur 1;
- Figur 4:: eine Schematische Darstellung eines Kühlsystems umfassend den Kühler gemäß Figur 1;
- Figur 5:: eine Draufsicht auf die Dampfkammer gemäß Figur 2 oder Figur 3; und
- Figur 6:: eine Schematische Darstellung eines Verfahrensablaufs zum Betreiben des Kühlers gemäß Figur 1.

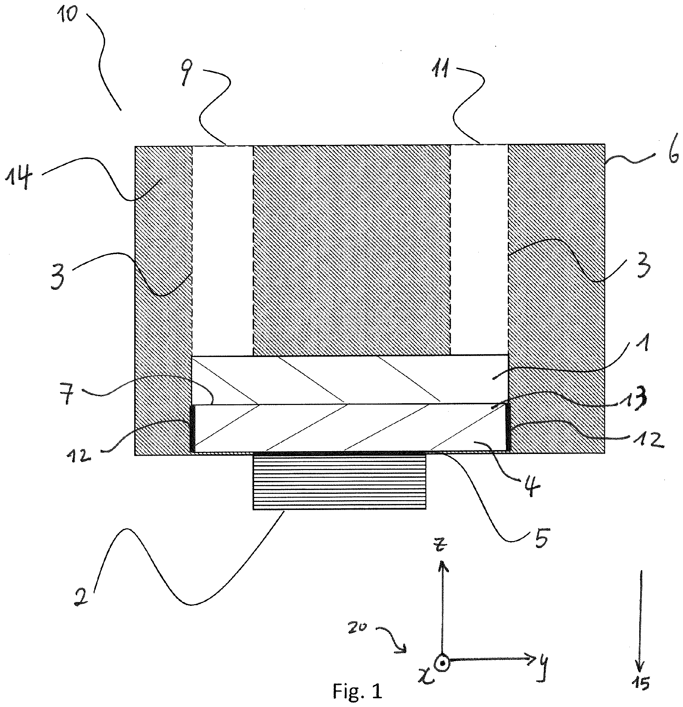

Figur 1 zeigt eine Schnittdarstellung eines Kühlers 10 zum Kühlen eines Prozessors 2, wobei der Kühler 10 im Profil im Wesentlichen rechteckig ausgeformt ist. Eine Richtung der Schwerkraft 15 zeigt in der Figur 1 nach unten und kann als negative z-Richtung eines kartesischen Koordinatensystems 20 angesehen werden. Das Profil des Kühlers 10 ist allerdings nicht auf rechteckige Form beschränkt, kann z. B. auch elliptisch oder anders geformt sein. Es sei weiter angemerkt, dass zur Übersicht lediglich der Prozessor 2 ohne weitere Komponenten gezeigt ist. Typischerweise ist der Prozessor 2 auf einer Platine (nicht gezeigt) angeordnet, wobei die Platine wiederum in einem Gehäuse eines PCs angeordnet sein kann. Der Prozessor 2 kann eine CPU und/oder eine GPU sein, insbesondere eines Desktop-PCs. Der Kühler 10 umfasst einen Kühlkörper 6, welcher eine Dampfkammer 4 (Englisch: Vapor Chamber) für ein erstes Kühlfluid und einen Kühlkanal 3 zum Durchleiten einer zweiten Kühlflüssigkeit aufweist, wobei der Kühlkanal 3 durch den Kühlkörper 6 verläuft.

Die Dampfkammer 4 ist in der Regel eine geschlossene bzw. dicht abschließbare Kammer und weist eine erste Kühlfläche 5 und eine der ersten Kühlfläche 5 gegenüberliegende zweite Kühlfläche 7 auf. In Figur 1 sind die erste Kühlfläche 5 und die zweite Kühlfläche 7 parallel zueinander angeordnet. Auf der ersten Kühlfläche 5 ist der Prozessor 2 bereits angeordnet und steht mit der ersten Kühlfläche 5 in thermischem kontakt. Jedoch ist der Kühler 10 zerstörungsfrei und lösbar mit dem Prozessor 2 verbunden, sodass der Kühler 10 wieder von dem Prozessor 2 abgenommen werden kann. Der Kühler 10, zum Beispiel die erste Kühlfläche 5, kann eine Befestigungseinrichtung für den Prozessor 2 aufweisen, sodass die Kühlfläche 5 mit dem Prozessor 2 verbunden werden kann. Weiter kann der Kühlkörper 6 ein Gehäuse 14 aufweisen. Der Kühlkanal 3 verläuft dann typischerweise durch das Gehäuse 14. Alternativ oder zusätzlich zur genannten Befestigungseinrichtung kann eine weitere Befestigungseinrichtung für den Prozessor 2 an oder in dem Gehäuse 14 angeordnet sein kann. Die Befestigungseinrichtung kann z. B. ein beliebiges geeignetes Mittel zum Befestigen des Kühlers 10 relativ zum Prozessor 2 sein oder umfassen, z. B. Schrauben, Klammern, oder Klebstoffe usw.

Unabhängig von der Position der Befestigungseinrichtung für den Prozessor 2 kann die erste Kühlfläche 5 in direktem thermischen Kontakt mit dem Prozessor 2 stehen, damit die Abwärme des Prozessors 2 gezielt und unmittelbar in die Dampfkammer 4 übertragen wird. Der direkte thermische Kontakt schließt den Anwendungsfall ein, in dem eine wärmeleitfähige Paste oder ein Wärmepad zwischen dem Prozessor 2 und der ersten Kühlfläche 5 angeordnet ist, um etwaige Unebenheiten auf den thermischen Verbindungsflächen auszugleichen.

Die erste Kühlfläche 5 kann an die der ersten Kühlfläche 5 zugewandte Oberfläche des Prozessors 2 angepasst sein. Wenn der Prozessor 2 z. B. eine komplexe Form aufweist, kann die erste Kühlfläche 5 eine hierzu komplementäre Form aufweisen, um einen besseren Kontakt mit dem Prozessor 2 zu bilden. In der Regel sind aber die der ersten Kühlfläche 5 zugewandten Oberfläche des Prozessors und die Kühlfläche 5 im Wesentlichen als ebene Flächen ausgestaltet.

Es ist in manchen Ausführungsformen möglich, mehrere Prozessoren 2 und/oder zusätzlich zu einem Prozessor 2 eine weitere elektronische Komponente, durch den Kühler 10 zu kühlen, indem sie ebenfalls mit der ersten Kühlfläche 5 verbunden werden und somit in thermischem Kontakt stehen.

Die erste Kühlfläche 5 kann eine zusätzliche Beschichtung aufweisen, die den Wärmeübertragungskoeffizienten erhöht.

Die zweite Kühlfläche 7 ist dem Kühlkanal 3 zugewandt und verläuft parallel zum Kühlkanal 3. Diese Anordnung bietet der zweiten Kühlflüssigkeit weniger Widerstand und ändert die Strömungsrichtung der zweiten Kühlflüssigkeit im Kühlkanal 3 nicht. Die Oberfläche der zweiten Kühlfläche 7 kann zumindest gleich oder größer als die der ersten Kühlfläche 5 zugewandte Oberfläche des Prozessors 2 sein, vorzugsweise größer als das Zweifache der Oberfläche des Prozessors 2. Dies gewährleistet eine zuverlässige Kühlung.

Die erste Kühlfläche 5 und die zweite Kühlfläche 7 sind beide Außenflächen der Dampfkammer 4 und können durch eine erste Platte und eine zweite Platte realisiert sein. Die erste Platte und/oder die zweite Platte sind vorzugsweise aus Kupfer hergestellt. Es sei angemerkt, dass die Platten sich nicht ausschließlich auf flache Platten beziehen und eine andere Form aufweisen können, s. unten.

Mehrere parallele Kühlrippen 1 (nur eine Kühlrippe ist durch den gewählten Schnitt in der Fig. 1 sichtbar) sind auf der zweiten Kühlfläche 7 angeordnet und senkrecht zur zweiten Kühlfläche 7 ausgerichtet. Die Kühlrippen 1 weisen zwar eine viereckige Schnittform in Figur 1 auf, sind aber nicht auf die Form beschränkt. Zumindest eine der Kühlrippen 1 ist aus Kupfer, Edelstahl, Titan oder Aluminium hergestellt.

In Figur 1 weist der Kühlkanal 3 einen Einlass 9 und einen Auslass 11 für die zweite Kühlflüssigkeit auf, sodass eine Strömungsrichtung der zweiten Kühlflüssigkeit vom Einlass 9 zum Auslass 11 definiert ist. Die Kühlrippen 1 sind entlang der Strömungsrichtung der zweiten Kühlflüssigkeit und parallel zur Strömungsrichtung der zweiten Kühlflüssigkeit derart im Kühlkanal 3 angeordnet, dass die zweite Kühlflüssigkeit durch die Kühlrippen 1 strömbar ist. Dadurch wird ein effektiver Wärmeaustausch gewährleistet.

In Figur 1 ist die Schnittform des Kühlkanals 3 U-förmig, aber die vorliegende Erfindung ist nicht auf die U-Form beschränkt. Am Einlass 9 und am Auslass 11 des u-förmigen Kühlkanals 3 können Befestigungsmittel für weitere Fluidleitungen angeordnet sein (nicht gezeigt), sodass die zweite Kühlflüssigkeit über eine erste Fluidleitung zum Einlass 9 des Kühlkanals 3 eingeleitet und über eine zweite Fluidleitung vom Auslass 11 des Kühlkanal 3 ausgeleitet wird. Strömt die zweite Kühlflüssigkeit aus dem Auslass 11 des Kühlkanals 3 über die Kühlrippen 1 aus, so wird die von der zweiten Kühlflüssigkeit aufgenommene Abwärme abgeführt.

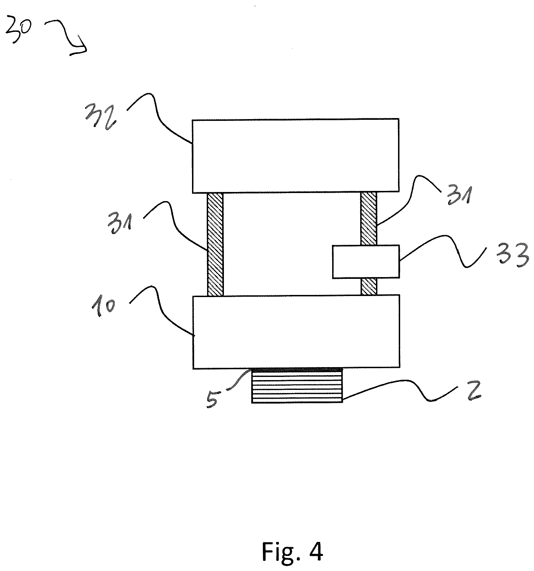

Selbst wenn die Figur 1 keine Pumpe zeigt, kann der Kühler 10 eine Pumpe umfassen, mittels der die zweite Kühlflüssigkeit durch die Kühlrippen 1 im Kühlkanal 3 pumpbar ist, vgl. Fig. 4. Zusätzlich kann der Kühler 10 einen geschlossenen Flüssigkeitskreislauf aufweisen, in welchem die zweite Kühlflüssigkeit zirkuliert. Insbesondere kann die zweite Kühlflüssigkeit mithilfe der Pumpe in den geschlossenen Flüssigkeitskreislauf derart gepumpt werden, dass die zweite Kühlflüssigkeit durch dem Einlass 9 in den Kühlkanal 3 einströmt und aus einem Auslass 11 des Kühlkanals 3 herausströmt.

In der Fig. 1 sind die erste Kühlfläche 5 und die zweite Kühlfläche 7 im bestimmungsgemäßen Gebrauch des Kühlers 10 senkrecht zur Schwerkraft 15 ausgerichtet, wobei alternativ auch andere Ausrichtungen möglich sind.

Die Dampfkammer 4 hat einen Kondensationsbereich (den oberen Bereich der Dampfkammer 4), einen Verdampfungsbereich (den unteren Bereich der Dampfkammer 4) und einen Hohlraum zwischen dem Kondensationsbereich und dem Verdampfungsbereich. Der Kondensationsbereich der Dampfkammer 4 grenzt an die zweite Kühlfläche 7 der Dampfkammer 4 an und der Verdampfungsbereich grenzt an die erste Kühlfläche 5 der Dampfkammer 4 an. Die Dampfkammer 4 inkl. der ersten und der zweiten Kühlfläche kann aus Kupfer, Edelstahl, Titan oder Aluminium hergestellt sein, sodass die Übertragung der Abwärme möglichst schnell erfolgen kann. Die Dampfkammer 4 kann ein Gehäuse umfassen, wobei die Kühlflächen 5, 7 an Gehäusewänden vorgesehen sein können. Die erste Kühlfläche 5 kann zum Beispiel Bestandteil einer wannenförmigen Bodenplatte sein. Die zweite Kühlfläche 7 kann Bestandteil einer ebenen oder wannenförmigen Deckplatte sein, wobei die Deckplatte und die Bodenplatte miteinander verbindbar sind und das Gehäuse der Dampfkammer 4 bilden.

Wird der Prozessor 2 betrieben, erzeugt der Prozessor 2 Abwärme. Durch den thermischen Kontakt mit der ersten Kühlfläche 5 wird die Abwärme des Prozessors 2 auf die erste Kühlfläche 5 und damit in den Verdampfungsbereich der Dampfkammer 4 übertragen, wo das erste Kühlfluid im flüssigen Zustand verdampft wird. Das verdampfte, d. h. gasförmige erste Kühlfluid, steigt auf und erreicht den Kondensationsbereich. Aufgrund der Kälte der zweiten Kühlfläche 7 bzw. der darauf fließenden zweiten Kühlflüssigkeit überträgt das erste Kühlfluid die Abwärme des Prozessors 2 an die zweite Kühlfläche 7 und damit die zweite Kühlflüssigkeit und geht als Folge im Kondensationsbereich vom gasförmigen Zustand in den flüssigen Zustand über. Unter der Wirkung der Schwerkraft tropft das flüssige erste Kühlfluid vom Kondensationsbereich in den Verdampfungsbereich zurück. Um das Tropfen zu begünstigen, können im Hohlraum Säulen angeordnet sein, welche sich vom Kondensationsbereich zum Verdampfungsbereich erstrecken und ebenfalls als Abstandshalter fungieren.

In einer anderen Ausführungsform kann die Dampfkammer 4 entgegen der Schwerkraftrichtung 15 angeordnet oder ausgerichtet sein, so dass das gasförmige Kühlfluid von der ersten Kühlfläche 5 absinkt und an der zweiten Kühlfläche 7 kondensiert. In dieser Ausführungsform wird die Anordnung des Kühlers 10 der Fig. 1 wird um 180 Grad gedreht.

Alternativ kann sich das gasförmige Kühlfluid seitlich von der ersten Kühlfläche 5 zur zweiten Kühlfläche 7 bewegen und dort kondensieren, wenn der Kühler 10 senkrecht zur Schwerkraftrichtung 15 angeordnet oder ausgerichtet ist. Das heißt, die Anordnung des Kühlers 10 der Fig. 1 wird in diesem Fall um 90 Grad gedreht.

Einbaulage des Kühlers 10 und damit Ausrichtung der Dampfkammer 4 können somit variabel gestaltet sein und müssen nicht zwingend von der Schwerkraft abhängen.

Andere physikalische Wirkungsweisen zum Transportieren des ersten Kühlfluids innerhalb der Dampfkammer 4, wie z.B. Kapillarwirkung, sind ebenfalls möglich und dem Fachmann geläufig.

Das erste Kühlfluid in der Dampfkammer 4 kann Wasser, Ethanol, Methanol, Ammoniak oder eine Mischung davon umfassen. Zusätzlich oder alternativ kann die zweite Kühlflüssigkeit im Kühlkanal 3 Wasser und ggf. Korrosionsschutzmittel und/oder Antifrostmittel umfassen. Das Antifrostmittel kann z. B. Glykol umfassen oder sein.

Optional kann der Kühlkörper 6 ein Gehäuse 14 aufweisen, durch welches der Kühlkanal 3 verläuft. Zwischen dem Gehäuse 14 des Kühlkörpers 6 und der Dampfkammer 4 kann ein Elastomerdichtungselement 12 angeordnet sein, um den Kühlkanal 3 abzudichten. Zudem kann das Gehäuse 14 des Kühlkörpers 6 aus Aluminium, vorzugsweise mittels Druckguss, hergestellt sein. Da sich das Aluminium des Gehäuses 14 und das Kupfer der Dampfkammer 4 nicht gut löten bzw. verschweißen lassen, kann das Elastomerdichtungselement 12 außerdem ausgestaltet sein, die Dampfkammer 4 mit dem Gehäuse 14 des Kühlkörpers 6 zu verbinden. Dies kann auch bei einer anderen Materialwahl zutreffen und ist nicht auf die genannte Kombination Kupfer und Aluminium beschränkt.

Das Gehäuse 14 des Kühlkörpers 6 kann eine erste Schale und eine mit der ersten Schale verbundene zweite Schale aufweisen. Die beiden Schalen bilden dann den Kühlkanal 3. Das Gehäuse 14 bzw. die Schalen können eine Aufnahme 13 für die Dampfkammer 4 bilden.

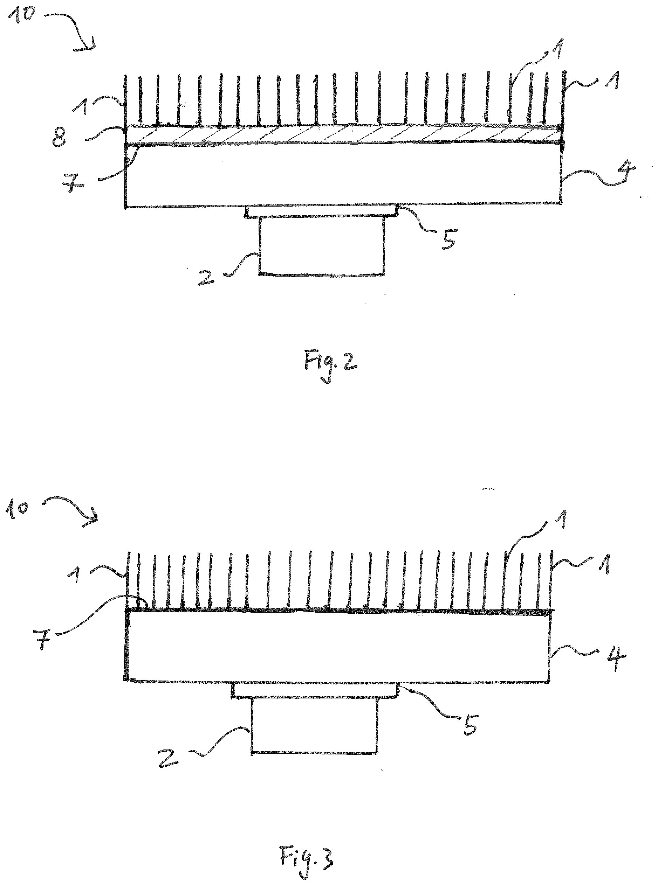

Fig. 2 zeigt eine Seitenansicht einer ersten Ausführungsform der Dampfkammer 4 gemäß der Figur 1. In der ersten Ausführungsform sind die Kühlrippen 1 auf einer separaten Platte 8 angeordnet bzw. in diese Platte 8 eingeformt, die mit der zweiten Kühlfläche 7 der Dampfkammer 4 thermisch verbunden ist. Die Kühlrippen 1 können durch einen Säge- oder Wälzschälvorgang der separaten Platte 8 hergestellt sein.

Wenn die Kühlrippen 1 mittels eines Sägevorgangs hergestellt sind, weisen sie im Querschnitt üblicherweise eine viereckige Form auf. Wenn jedoch die Kühlrippen 1 mittels eines Wälzschälvorgangs hergestellt sind, können sie im Querschnitt eine andere Form aufweisen.

Figur 3 zeigt eine Seitenansicht einer zweiten alternativen Ausführungsform des Kühlers 10 gemäß der Figur 1. In der zweiten Ausführungsform sind die Kühlrippen 1 integraler Bestandteil eines Gehäuses der Dampfkammer 4, insbesondere integraler Bestandteil einer Deckplatte des Gehäuses. Anstatt auf der separaten Platte 8 können die Kühlrippen 1 mittels eines Säge- oder Wälzschälvorgangs direkt auf der zweiten Kühlfläche 7 der Dampfkammer 4 hergestellt sein. Dafür kann beispielsweise die zweite Kühlfläche 7 der Dampfkammer 4 eine bestimmte Dicke aufweisen. Die Dicke der zweiten Kühlfläche kann größer sein als eine Dicke der ersten Kühlfläche. Im Vergleich zur ersten Ausführungsform gemäß der Fig. 2 erspart die zweite Ausführungsform einen nachträglichen Verbindungsarbeitsgang.

Figur 4 zeigt schematische Darstellung eines Kühlsystems 30 zum Kühlen eines Prozessors 2. Das Kühlsystem 30 weist einen Kühler 10 gemäß einer der Figuren 1 bis 3, zwei Fluidleitungen 31, eine Pumpe 33, und einen Radiator 32 auf, wobei der Kühler 10 über die Fluidleitungen 31 fluidisch mit dem Radiator 32 verbunden ist. Die zweite Kühlflüssigkeit kann mittels der Pumpe 33 durch die Fluidleitungen 31, den Radiator 32 und den Kühlkanal 3 des Kühlers 10 gepumpt sein. Die Abwärme, die vom Prozessor 2 erzeugt wird, kann vom Kühler 10 aufgenommen und an die zweite Kühlflüssigkeit abgegeben werden. Die zweite Kühlflüssigkeit wird anschließend mit der Pumpe 33 durch die Fluidleitungen 31 zu dem Radiator 32 gepumpt. Der Radiator 32 kann die zweite Kühlflüssigkeit derart kühlen, dass die Wärme der zweiten Kühlflüssigkeit über den Radiator 32 an die den Radiator 32 umgebende Luft abgegeben wird. Dazu kann das Kühlsystem 30 einen Lüfter (nicht gezeigt) aufweisen. Der Lüfter kann am Radiator 32 angeordnet und/oder befestigt sein, und die Luft bewegen, an die der Radiator 32 Wärme abgibt. Durch die Bewegung der Luft, also den Luftstrom des Lüfters werden der Radiator 32 bzw. die zweite Kühlflüssigkeit gekühlt. Es sind anstelle des Radiators 32 jegliche Mittel denkbar, die eine Abkühlung der zweiten Kühlflüssigkeit bewirken können. Optional oder ergänzend ist auch eine Luftkühlung mittels Ventilatoren und/oder Lüfter vorstellbar. In einer optionalen Ausgestaltung kann das Kühlsystem 30 zumindest einen Sensor zum Steuern der Pumpe 33 und/oder des Radiators 32 umfassen.

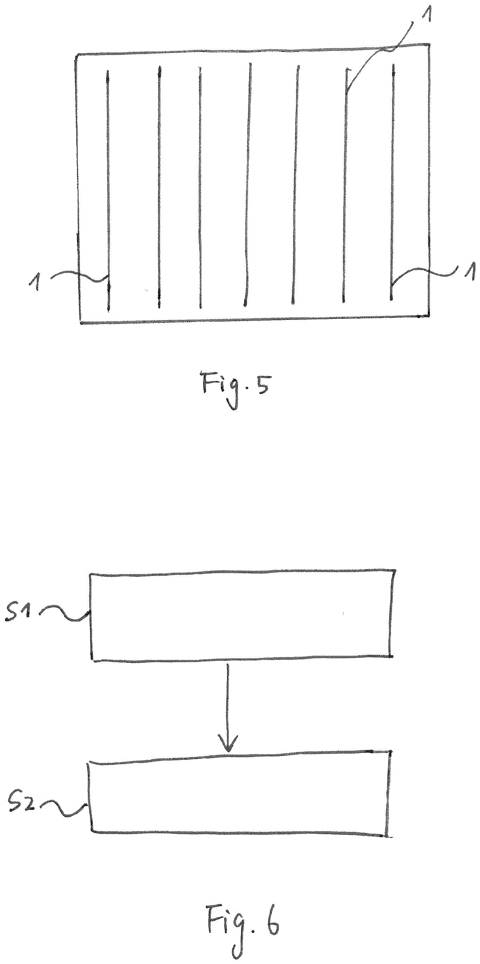

Fig.5 zeigt eine Draufsicht auf die Dampfkammer 4 der Figur 2 oder Figur 3. In Figur 5 weisen alle Kühlrippen 1 die gleiche Form, die gleiche Länge und den gleichen Abstand zwischen den jeweiligen benachbarten Kühlrippen 1 auf. Jedoch können die Form und/oder die Länge zumindest einer der Kühlrippen 1 und/oder der Abstand zwischen zwei benachbarten Kühlrippen 1 je nach Bedarf variieren. Die Kühlrippen 1 können abschnittsweise im Querschnitt rund, elliptisch und/oder polygonförmig, z.B. trapezförmig oder viereckig, sein.

Der Verlauf der Kühlrippen 1 kann an den Verlauf des Kühlkanals 3 angepasst sein. Der Verlauf des Kühlkanals 3 kann wiederum an die Geometrie des Kühlkörpers 6 angepasst sein. Vorzugsweise kann der Verlauf der Kühlrippen 1 gleich oder zumindest abschnittsweise ähnlich wie der Verlauf des Kühlkanals 3 sein. Somit kann die zweite Kühlflüssigkeit entlang des Verlaufs der Kühlrippen 1 effektiv ein- und ausgeleitet werden.

Fig.6 zeigt eine schematische Darstellung eines Verfahrensablaufs zum Betreiben des Kühlers 10 gemäß einer der Figuren 1 bis 5. Der Verfahrensablauf umfasst zwei Verfahrensschritte S1 und S2.

Im Verfahrensschritt S1 der Figur 6 wird der Prozessor 2 auf der ersten Kühlfläche 5 der Dampfkammer 4, z. B. mittels einer Befestigungseinrichtung wie oben beschrieben, befestigt.

Anschließend wird der Prozessor 2 im Verfahrensschritt S2 gekühlt, indem die zweite Kühlflüssigkeit durch den Einlass 9 des Kühlkanals 3 geleitet wird und das erste Kühlfluid durch die Abwärme des Prozessors 2 zwischen dem gasförmigen und dem flüssigen Zustand in der Dampfkammer 4 umgewandelt wird.

Das in Figur 6 gezeigte Verfahren ist nicht auf die Schritte S1 und S2 beschränkt und kann weitere Schritte aufweisen, welche zum Beispiel im Zusammenhang mit dem Kühler 10 und/oder dem System 30 beschrieben sind. Unabhängig davon können die Schritte S1 und S2 wiederholt werden.

### Bezugszeichenverzeichnis:

- 1: Kühlrippen
- 2: Prozessor
- 3: Kühlkanal
- 4: Dampfkammer
- 5: Erste Kühlfläche der Dampfkammer
- 6: Kühlkörper
- 7: Zweite Kühlfläche der Dampfkammer
- 8: Separate Platte
- 9: Einlass des Kühlkanals
- 10: Kühler
- 11: Auslass des Kühlkanals
- 12: Elastomerdichtungselement
- 13: Aufnahme für die Dampfkammer
- 14: Gehäuse des Kühlkörpers
- 15: Richtung der Schwerkraft
- 20: Koordinatensystem
- 30: Kühlsystem
- 31: Fluidleitungen
- 32: Radiator
- 33: Pumpe
- S1: Aufbringen des Prozessors auf der ersten Kühlfläche
- S2: Kühlen des Prozessors

## Patentansprüche

1. Kühler (10) zum Kühlen eines Prozessors (2), insbesondere einer CPU oder einer GPU, umfassend:
einen Kühlkörper (6) mit einer Dampfkammer (4) für ein erstes Kühlfluid und einem Kühlkanal (3) zum Durchleiten einer zweiten Kühlflüssigkeit, der durch den Kühlkörper (6) verläuft,
wobei die Dampfkammer (4) eine erste Kühlfläche (5) und eine der ersten Kühlfläche (5) gegenüberliegende zweite Kühlfläche (7) aufweist,
wobei der Prozessor (2) auf der ersten Kühlfläche (5) der Dampfkammer (4) anordenbar ist und das erste Kühlfluid in der Dampfkammer (4) durch Wärme des Prozessors (2) zwischen gasförmigem und flüssigem Zustand umwandelbar ist,
wobei die zweite Kühlfläche (7) der Dampfkammer (4) dem Kühlkanal (3) zugewandt ist und im Wesentlichen parallel zum Kühlkanal (3) verläuft,
wobei eine Vielzahl von parallelen Kühlrippen (1) auf der zweiten Kühlfläche (7) der Dampfkammer (4) angeordnet und senkrecht zur zweiten Kühlfläche (7) der Dampfkammer (4) ausgerichtet ist,
wobei die Kühlrippen (1) entlang einer Strömungsrichtung der zweiten Kühlflüssigkeit und parallel zur Strömungsrichtung der zweiten Kühlflüssigkeit derart im Kühlkanal (3) angeordnet sind, dass die zweite Kühlflüssigkeit durch die Kühlrippen (1) strömbar ist.

2. Kühler (10) nach dem vorhergehenden Anspruch, wobei die Kühlrippen (1) integraler Bestandteil eines Gehäuses der Dampfkammer (4) sind oder wobei die Kühlrippen (1) durch eine separate Platte (8) ausgebildet sind, die mit der zweiten Kühlfläche (7) der Dampfkammer (4) verbunden ist.

3. Kühler (10) nach einem der vorhergehenden Ansprüche, wobei die erste Kühlfläche (5) der Dampfkammer (4) eine Befestigungseinrichtung für den Prozessor aufweist, oder wobei der Kühlkörper (6) ein Gehäuse aufweist, durch welches der Kühlkanal (3) verläuft und an oder in welchem eine Befestigungseinrichtung für den Prozessor (2) angeordnet ist, wobei der Kühler (10) vorzugsweise abnehmbar an dem Prozessor (2) befestigt werden kann.

4. Kühler (10) nach einem der vorhergehenden Ansprüche, derart konfiguriert, dass die erste Kühlfläche (5) der Dampfkammer (4) in direktem Kontakt mit dem Prozessor (2) stehen kann.

5. Kühler (10) nach einem der vorhergehenden Ansprüche, wobei die erste Kühlfläche (5) der Dampfkammer (4) und die zweite Kühlfläche (7) der Dampfkammer (4) parallel zueinander angeordnet sind.

6. Kühler (10) nach einem der vorhergehenden Ansprüche, wobei die erste Kühlfläche (5) der Dampfkammer (4) und die zweite Kühlfläche (7) der Dampfkammer (4) durch eine erste Platte und eine zweite Platte ausgebildet sind, und wobei die erste Platte und/oder die zweite Platte vorzugsweise aus Kupfer hergestellt sind.

7. Kühler (10) nach einem der vorhergehenden Ansprüche, wobei der Kühler (10) eine Pumpe (33) umfasst und die zweite Kühlflüssigkeit mittels der Pumpe (33) durch die Kühlrippen (1) im Kühlkanal (3) pumpbar ist, und/oder wobei der Kühler (10) einen geschlossenen Flüssigkeitskreislauf aufweist und die zweite Kühlflüssigkeit im Flüssigkeitskreislauf zirkuliert.

8. Kühler (10) nach einem der vorhergehenden Ansprüche, wobei die Dampfkammer (4) einen Kondensationsbereich, einen Verdampfungsbereich und einen Hohlraum zwischen dem Kondensationsbereich und dem Verdampfungsbereich aufweist, wobei der Kondensationsbereich an die zweite Kühlfläche (7) der Dampfkammer (4) und der Verdampfungsbereich an die erste Kühlfläche (5) der Dampfkammer (4) angrenzen.

9. Kühler (10) nach einem der vorhergehenden Ansprüche, wobei mindestens eine der Kühlrippen (1) in Form einer gesägten Kühlrippe oder einer geschälten Kühlrippe ausgebildet ist.

10. Kühler (10) nach einem der vorhergehenden Ansprüche, wobei mindestens eine der Kühlrippen (1) und/oder ein Gehäuse der Dampfkammer (4) aus Kupfer, Edelstahl, Titan oder Aluminium hergestellt sind.

11. Kühler (10) nach einem der vorhergehenden Ansprüche, wobei der Kühlkörper (6) ein Gehäuse (14) aufweist, durch welches der Kühlkanal (3) verläuft, und wobei das Gehäuse (14) des Kühlkörpers (6), insbesondere der Kühlkanal (3), mittels eines zwischen dem Gehäuse (14) und der Dampfkammer (4) angeordneten Elastomerdichtungselements (12) abgedichtet ist.

12. Kühler (10) nach dem vorhergehenden Anspruch, wobei das Gehäuse (14) des Kühlkörpers (6) aus Aluminium, vorzugsweise mittels Druckguss, hergestellt ist, und/oder wobei das Gehäuse (14) des Kühlkörpers (6) eine erste Schale und eine mit der ersten Schale verbundene zweite Schale aufweist, und die beiden Schalen den Kühlkanal (3) bilden.

13. Kühler (10) nach Anspruch 12, wobei das Gehäuse (14) des Kühlkörpers (6) und/oder mindestens eine der beiden Schalen eingerichtet ist, die Dampfkammer (4) aufzunehmen.

14. Kühler (10) nach einem der vorhergehenden Ansprüche, wobei das erste Kühlfluid Wasser, Ethanol, Methanol, Ammoniak oder eine Mischung davon umfasst und/oder wobei die zweite Kühlflüssigkeit Wasser umfasst, ggf. Korrosionsschutzmittel und/oder Antifrostmittel umfasst.

15. Verfahren zum Kühlen eines Prozessors (2) unter Verwendung des Kühlers (10) nach einem der Ansprüche 1 bis 14, umfassend:
- (S1) Befestigen des Prozessors (2) auf der ersten Kühlfläche (5) der Dampfkammer (4); und
- (S2) Kühlen des Prozessors (2), indem die zweite Kühlflüssigkeit durch den Kühlkanal (3) geleitet wird und das erste Kühlfluid durch die Wärme des Prozessors (2) zwischen dem gasförmigen und dem flüssigen Zustand umgewandelt wird.
